# EUROPEAN PATENT APPLICATION

(11) **EP 4 373 229 A1**
(43) Date of publication of application: **22.05.2024**
(21) Application number: 23206504.5
(22) Date of filing: 27.10.2023
(51) Int. Cl.: H05K 7/14

(54) **ELECTRIC PANEL SYSTEM**

(30) Priority: 16.11.2022 US 202263425881 P; 19.09.2023 US 202318470089
(71) Applicant: Transportation IP Holdings, LLC, Norwalk, CT 06851 (US)
(72) Inventor: MURPHY, Mark, Norwalk, CT, 06851 (US); YOUNG, Henry Todd, Norwalk, CT, 06851 (US); KUTTENKULER, Jason Daniel, Norwalk, CT, 06851 (US); KRIVONAK, Andrew Louis, Norwalk, CT, 06851 (US); CARASTRO, Fabio, Norwalk, CT, 06851 (US); ZOELS, Thomas Alois, Norwalk, CT, 06851 (US); FANTAUZZO, Lucia, Norwalk, CT, 06851 (US); MARI CURBELO, Alvaro Jorge, Norwalk, CT, 06851 (US)
(74) Representative: Laufhütte, Dieter

(57) **Abstract**

A panel system (100) may include a core body (230) having opposite sides (336, 338) and switching devices (234) mounted to at least one of the opposite sides (336, 338) of the core body (230), a housing (102) in which the core body (230) and the switching devices (234) are disposed, gate drivers (120, 122) coupled to a first side of the housing (102) and to the switching devices (234), and connectors (116, 118) coupled to one or more other sides (336, 338) of the housing (102) and to the switching devices (234). The connectors (116, 118) may receive and conduct a voltage to collector terminals (246) of the switching devices (234). The gate drivers (120, 122) may conduct a gate voltage to gate terminals (246) of the switching devices (234). The switching devices (234) may control conduction of the voltage out of the housing (102) via the connectors (116, 118) as an alternating current.

## Description

### CROSS-REFERENCE TO RELATED APPLICATIONS

This application claims priority to U.S. Patent Application No. 17/470,089 (filed 19-September-2023), which claims priority to U.S. Provisional Application No. 63/425,881 (filed 16-November-2022), the entire disclosures of which are incorporated herein by reference.

### BACKGROUND

### Technical Field.

The subject matter described herein relates to electric panels that may have electronic components such as insulated gate bipolar transistors (IGBTs), driver boards, bus bars, and the like, for conditioning and/or controlling conduction of voltage and/or electric current.

### Discussion of Art.

Electric panels may be used in powered systems to condition and/or control conduction of electric energy, such as voltage and/or electric current. These panels may receive electric energy and convert the energy, such as by converting voltage into alternating current (AC). Some panels may handle relatively high voltages, such as over one kilovolt AC or over one thousand five hundred voltage direct current (DC). These panels may require driver boards with circuitry that controls, or drives, operation of the panels, and may include electronic switches such as IGBTs. These driver boards can generate significant heat and may need replacement due to undesirable operation of the driver boards over time.

But the size of some known panels may be larger than is desirable. This increased size can result from the addition of more driver boards, more space for heat dissipation, and the like. It may be desirable to have a system and method that differs from those that are currently available.

### BRIEF DESCRIPTION

In one example, a panel system is provided that may include a core body having opposite sides and switching devices mounted to at least one of the opposite sides of the core body, a housing in which the core body and the switching devices are disposed, gate drivers coupled to a first side of the housing and to the switching devices, and connectors coupled to one or more other sides of the housing and to the switching devices. The connectors may receive and conduct a voltage to collector terminals of the switching devices. The gate drivers may conduct a gate voltage to gate terminals of the switching devices. The switching devices may control conduction of the voltage out of the housing via the connectors as an alternating current.

In another example, a method is provided that may include removing a top or a bottom busbar from a panel system having a core body with switching devices mounted to opposite sides of the core body, a housing in which the core body and the switching devices are disposed, gate drivers coupled to a first side of the housing, and connectors coupled to other sides of the housing and to the switching devices. The method also may include removing at least one of the switching devices from the core body, coupling a replacement switching device to the core body where the at least one of the switching devices was removed, and coupling the top or the bottom busbar to the panel system.

In another example, a kit is provided. The kit may be used in replacing at least one switching device coupled to a core body in a housing of a panel system also having gate drivers coupled to a first side of the housing and connectors coupled to other sides of the housing and to the switching devices. The kit may include a replacement switching device configured to be mounted to the core body.

In another example, another panel system may include a core body having opposite sides and switching devices mounted to at least one of the opposite sides of the core body. The core body may include internal conduits for flow of a fluid used to thermally manage the switching devices. The panel system may include a housing in which the core body and the switching devices are disposed, gate drivers coupled to a front side of the housing and to the switching devices, and supply connectors coupled to a first side of the housing and load connectors coupled to a second side of the housing with the front side disposed between the front side and the second side. The supply connectors may receive and conduct a voltage to collector terminals of the switching devices. The gate drivers may conduct a gate voltage to gate terminals of the switching devices. The switching devices may control conduction of the voltage out of the housing via the load connectors as an alternating current.

### BRIEF DESCRIPTION OF THE DRAWINGS

The subject matter may be understood from reading the following description of non-limiting embodiments, with reference to the attached drawings, wherein below:
Figure 1 illustrates a perspective view of one example of an electric panel system;
Figure 2 illustrates another perspective view of the panel system shown in Figure 1 with a busbar and connectors removed;
Figure 3 illustrates a perspective view of one example of a core body of the panel system with switching devices mounted on the core body;
Figure 4 illustrates a perspective view of the core body shown in Figure 3 without the switching devices mounted on the core body; and
Figure 5 illustrates a cross-sectional view of one example of a top or bottom busbar of the panel system.

### DETAILED DESCRIPTION

Embodiments of the subject matter described herein relate to electric panel systems that may be used in powered systems to condition and/or control conduction of electric energy to various components of the powered system. For example, panel systems may be used to receive high voltages, convert the high voltages into AC, and output the AC to one or more loads for powering the loads. The powered systems may include vehicles or stationary systems, and the loads may include traction motors, auxiliary loads, or the like. One or more examples of the panel systems described herein may improve or optimize the space taken up by the panel systems and provide modular panel systems that can be used to fulfill multiple functions, as well as be easily swapped out for replacement panel systems or other, different panel systems. The panel systems may include thermal management assemblies that assist in maintaining temperatures of the components (e.g., switches, circuitry, etc.) within acceptable ranges, while avoiding consuming too much unnecessary additional space. The panel systems also may be shaped and include components for sharing current between components while matching inductances, isolating personnel from high voltages, and keeping the panel systems easy to assemble and maintain.

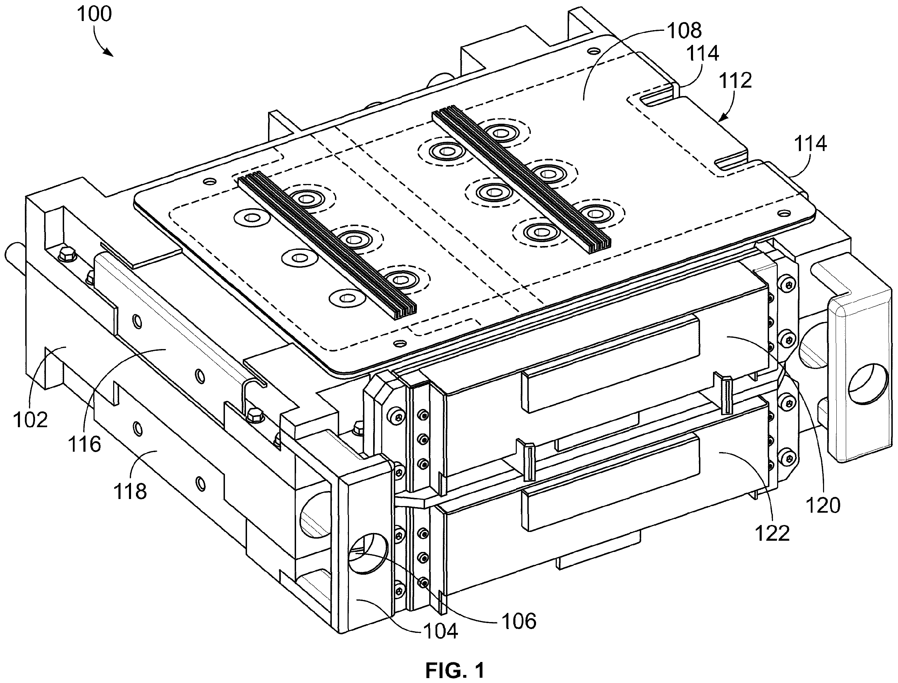

Figure 1 illustrates a perspective view of one example of an electric panel system 100. The panel system may be modular in that the panel system may be placed into a rack, a shelving system, or the like, during operation, but also may be removed from the rack, shelving system, or the like, and swapped out for a similar replacement panel system or a different panel system (e.g., a panel system performing different operations). The panel system may include a housing 102 that optionally has handles 104 that can be grasped to remove the panel system from a backside plane (e.g., within the rack, shelving system, etc., and to which the panel system may be electrically and/or fluidly connected) and/or to connect the panel system with the backside plane. The housing and/or handles may include fastening holes 106 sized to receive fasteners that can screw or otherwise fasten into the backside plane to secure the panel system to the backside plane.

A busbar 108 may be disposed at or on top of one side of the housing. A similar or identical busbar may be disposed at or below the opposite side of the housing. This busbar may be a laminated busbar having one or more conductive layers for conduction of electric energy (e.g., DC or AC). In one example, the busbar includes multiple conductive layers for impedance matching or balancing. Fasteners 110 (e.g., screws) may be used to fasten the busbar to electronic modules disposed in the housing (not visible in Figure 1). In the illustrated example, the busbar may include a bend 112 that may cause or allow the busbar to extend around a corner or edge of the housing (e.g., the right side of the housing in the perspective of Figure 1) and over or onto a first lateral side (e.g., right side) of the housing. The bent portion of the busbar that is not visible in Figure 1 may be conductively coupled with electrical connectors 114 to conductively couple the panel system to a source or supply of electric energy (e.g., voltage), such as a supply busbar. For example, different sets of the supply connectors 114 may be connected with the bus bar(s) on the top and bottom of the panel system. Each bus bar may be connected with switching devices (described below) on different sides of a core body (also described below).

Additional load electrical connectors 116, 118 may be disposed on a side of the housing that is opposite the electrical connectors connected to the bent portion of the busbar. For example, these additional electrical connectors may extend along a second lateral side of the housing (e.g., a left side) that is opposite the first lateral side of the housing. One of the additional electrical connectors may be conductively coupled with the busbar (e.g., top) of the panel system, and may connect to one side (e.g., a positive potential side) of one or more loads (e.g., such as traction motors, tools, electronic storage devices, or the like). The other of the additional electrical connectors may be conductively coupled with the other (e.g., bottom) busbar of the panel system, and may connect to another side (e.g., a negative potential side) of the one or more loads.

Gate drivers 120, 122 may be attached to a front side of the housing between the opposite lateral sides of the housing. The gate drivers optionally can be referred to as gate driving modules, gate driving circuitry, or the like. The gate drivers can be mounted vertically relative to each other (e.g., one gate driver is above the other gate driver) or may be mounted horizontally next to each other or in another orientation or arrangement. One gate driver 120 can control operation of switching devices (described below) on one side of the core body (with output signals or voltage from these switching devices being conducted to the top connector 116), and the other gate driver 122 can control operation of the switching devices on another (e.g., opposite) side of the core body (with output signals or voltage from these switching devices being conducted to the bottom connector 118).

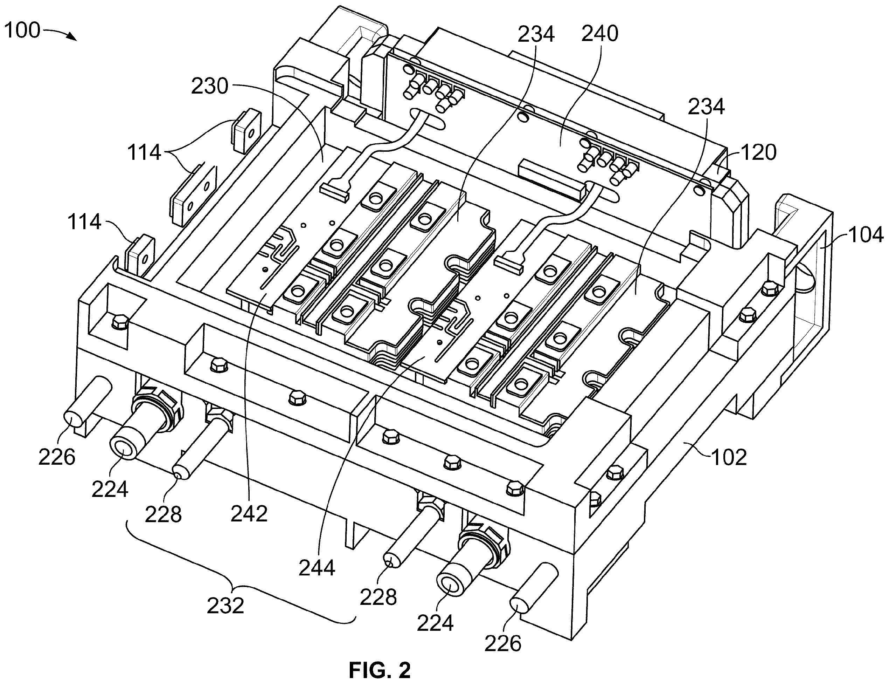

Figure 2 illustrates another perspective view of the panel system shown in Figure 1 with the busbar and connectors 116, 118 removed. The back side of the housing may include fluid ports 224 that may be fluidly coupled with or otherwise part of a core body 230 of a thermal management assembly 232 of the panel system (described below). The core body may be a planar object or body that is formed from non-conductive materials and/or that is electrically isolated from the switching devices (e.g., by a dielectric layer) such that voltage or current is not conducted into or by the core body. The fluid ports may include hydraulic connectors or other connectors connected to the core body. The fluid ports may be coupled with a fluid circuit in which a thermal management fluid may flow to control temperatures of components within the panel system. For example, the fluid ports may be coupled with one or more circuits that circulates a liquid coolant and/or a gas coolant to keep temperatures of the panel system to within acceptable ranges. Optionally, a heated liquid and/or a heated gas may be circulated in the circuit. The fluid may flow in the circuit, into the core body through one of the fluid ports, throughout conduits within the core body (described below) to cool, heat, or otherwise manage components of the panel system, out of the core body through another one of the fluid ports, and back into the remainder of the fluid circuit. This can help keep temperatures of components of the panel system to within acceptable ranges by cooling and/or heating the components.

The back side of the housing also may include connecting mechanisms 226 and/or guiding pins 228. The connecting mechanisms may include connectors that mate with corresponding cavities or connectors along a backplane to secure the housing to the backplane of the rack, shelves, etc. The guiding pins may be received into corresponding receptacles of the backplane to align the fluid ports and/or connecting mechanisms with the corresponding receptacles of the fluid circuit and connectors. The guiding pins may ensure that these components are aligned and may allow for blind mating of the panel system with the backplane (e.g., coupling the panel system with the backplane without the connectors, pins, mechanisms, etc. being visible.

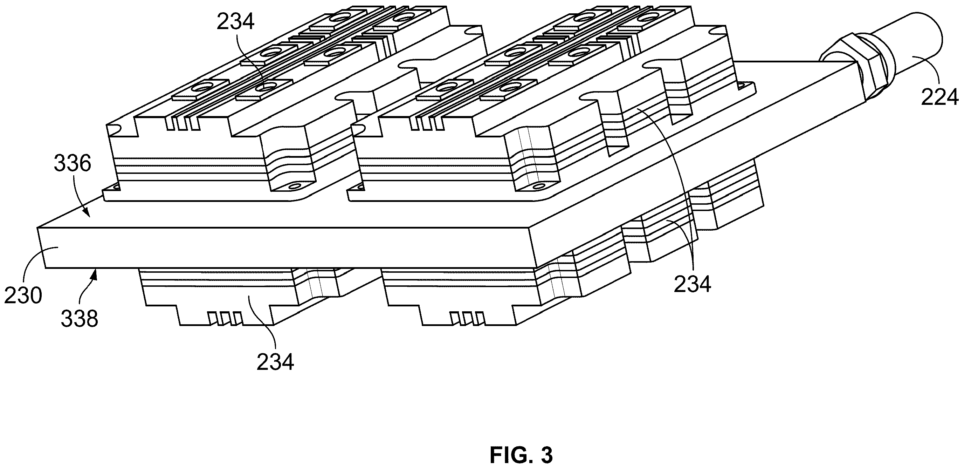

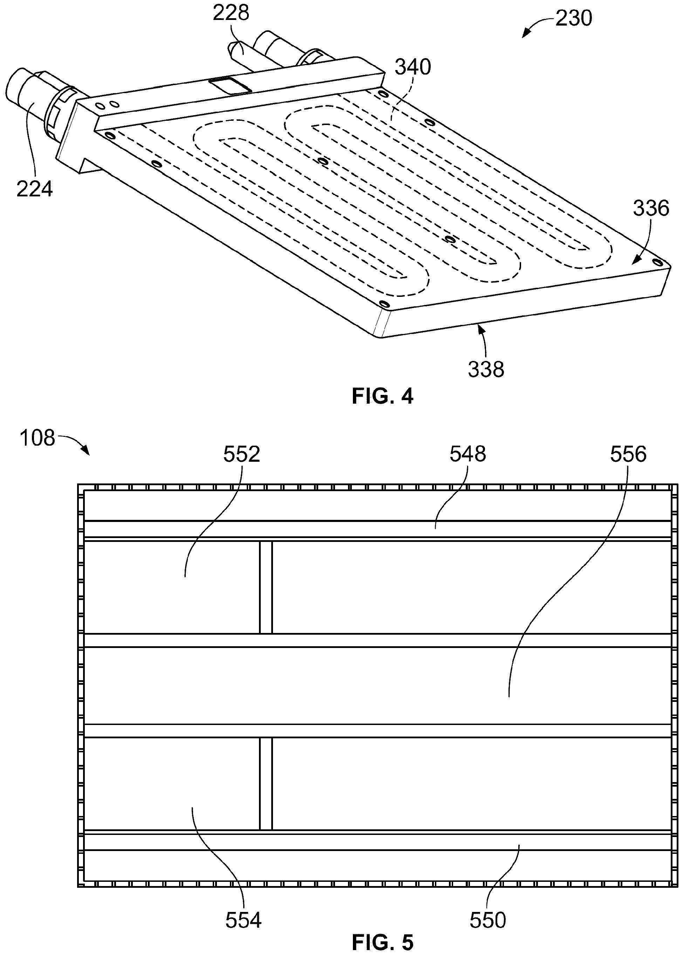

With continued reference to the panel system shown in Figure 2, Figure 3 illustrates a perspective view of one example of the core body with switching devices 234 mounted on the core body and Figure 4 illustrates a perspective view of the core body shown in Figure 3 without the switching devices mounted on the core body. The switching devices may be IGBTs or other electronically controlled switches. The core body may have opposite sides 336, 338 (labeled in Figure 3), with two switching devices mounted on each of the opposite sides of the core body (e.g., for a total of four switching devices). Alternatively, the core body may have the switching devices mounted on only a single side, the core body may have only a single switching device mounted on one or both of the sides, and/or may have more than two switching devices mounted on one or more of the sides. The gate drivers may be coupled with the switching devices via a shared circuit board 240 and separate circuit boards 242, 244 (or another device having conductive pathways). This can allow for the gate drivers to receive a single input signal (e.g., a single input voltage) but to split this input signal into multiple signals separately sent to each of the switching devices to allow for individual control of the switching devices. Alternatively, the input signal may not be split and separately sent to the switching devices. The switching devices may be conductively coupled with the bottom side of the bus bar 108.

In operation, input voltage is provided from a source (e.g., battery cells, fuel cells, an alternator, a generator, a utility grid, a converter, etc.) to the different sets of the input connectors 114. One set of these input connectors is conductively coupled with the switching devices on the top side 336 of the core body via the top bus bar 108 (visible in Figure 1). Another set of these input connectors is conductively coupled with the switching devices on the bottom side 338 of the core body via the bottom bus bar (on the side of the housing that is opposite the side on which the top bus bar 108 is shown). For example, collector terminals of the IGBTs may be conductively coupled with the input connectors via the corresponding bus bar on the top or bottom side of the housing.

The switching devices on the top of the core body also may be conductively coupled with the output or load connector 116 by the bus bar on top of the housing. The switching devices on the bottom of the core body may be conductively coupled with the output or load connector 118 by the bus bar on the bottom of the housing. For example, emitter terminals of the switching devices may be conductively coupled with the load connectors by the bus bars on top and bottom of the housing.

The gate drivers can be connected with the switching devices by the circuit boards 240, 242, 244. For example, the top gate driver can be connected with gate terminals of the switching devices on the top side of the core body. The bottom gate driver can be connected with the gate terminals of the switching devices on the bottom side of the core body. Input signals can be provided to the gate drivers (e.g., by a controller or other external system) to control the switching devices, which can control the voltage that is conducted through the switching devices from the supply connectors 114 to the load connectors 116, 118.

The busbars above and below the switching devices may be identical in construction, may be mounted vertically flipped 180° relative to each other, and may include several (e.g., five or a different number) of stacked material layers (described below). The switching devices on each side of the core body are arranged in a side-by-side arrangement, with one switching device located closer to the input or supply connectors 114 than the other switching device (for that side of the core body) and the other switching device located closer to the output or load connectors 116, 118 than the other switching device (for that side of the core body). This arrangement and disposition of the switching devices can result in the supply voltage or current supplied via the supply connectors being distributed substantially uniformly to equipotential terminals 246 of the switching devices (shown in Figure 2; for example, collector terminals for different phases of alternating current that is output by the switching devices).

Figure 5 illustrates a cross-sectional view of one example of one of the top or bottom busbars of the panel system. The busbars above and below the core body and switching devices may be formed as multi-layer stacks that include outer protective insulation layers 548, 550. These insulation layers can be formed from one or more dielectric material that both electrically isolate internal layers of the busbars from components outside of the busbar, and also protect the internal layers of the busbars from outside components. Internal conductive layers 552, 554 are disposed inside of the outer protective insulation layers. These conductive layers may conduct voltage or current along traces or other conductive paths from the input or supply connectors and/or the gate drivers to the switching devices (e.g., to collector and gate terminals of the switching devices, respectively), and from the switching devices to the output or load connectors (e.g., to emitter terminals of the switching devices). An internal dielectric layer 556 may be disposed between the conductive layers. This internal dielectric layer may be formed from one or more dielectric materials and may separate the conductive layers such that these layers are not conductively coupled with each other (unless one or more conductive vias are present extending through the internal dielectric layer from one conductive layer to another conductive layer).

This design of the busbars can provide substantially equivalent or equivalent inductances for the conduction of voltage or current into and/or out of the switching devices. The positions of the switching devices and the gate drivers may provide for equal inductances of the electric paths along which current or voltage is conducted into and/or out of each of the switching devices. Additionally, the positions and separation distances between the switching devices and the gate drivers has been found by the inventors to provide improved control or reduction of magnetic field interference (relative to other distances or positions).

As described above, the core body includes internal conduits 340 that fluidly couple the fluid ports of the core body. The cooling or heating liquid or gas in the fluid circuit described above may flow through these conduits to heat or cool the core body, and the switching devices. For example, if operation of the switching devices generates heat, then a coolant can flow through the internal conduits to cool the switching devices, core body, and other components. If the switching devices are operating in a cold environment and require heat to operate or improve operation, then a heated fluid can flow through the internal conduits to increase the temperature of the switching devices (or other components).

The panel system may provide accessibility to the gate drivers via the front of the panel system, provide side (e.g., left side) accessibility to the output or load connectors, provide opposite side (e.g., right side) accessibility to the supply or input connectors, provide bus bars on opposite sides (e.g., top and bottom sides) of the core body, provide fluid ports into and out of the core body, provide guiding pins to assist with positioning the panel system relative to a backplane, and/or provide a supportive and protective housing with handles to the front for grasping or handling the panel system. In the event of failure or another need to replace, inspect, or maintain the components of the panel system, providing this accessibility can aid in more easily removing and replacing components when compared with some known panel systems. In one embodiment, the subject matter described herein also provides a method for repairing or replacing a panel system. This method may include accessing the component(s) needed to be replaced via the front, side, top, or bottom of the panel system, removing the component(s), and installing replacement components through the same front, side, top, or bottom of the panel system. In one embodiment, the subject matter described herein provides for a replacement or repair kit that includes one or more of the components sought to be replaced and/or that includes the components of the panel system shown and described herein, where the components may be assembled as described herein to provide the panel system. For example, to replace a switching device, the method may include removing the panel system from the backplane, removing the top or bottom busbar, detaching the switching device from the internal busbar 230, 244 and from the top or bottom of the core body, attaching a replacement switching device to the top or bottom of the core body, attaching the replacement switching device to the internal busbar, attaching the top or bottom busbar, and connecting the panel system to the backplane. The replacement kit may include the replacement switching device, the internal busbar, and/or the top or bottom busbar.

While one or more embodiments are described in connection with a rail vehicle system, not all embodiments are limited to rail vehicle systems. Unless expressly disclaimed or stated otherwise, the subject matter described herein extends to other types of vehicle systems, such as automobiles, trucks (with or without trailers), buses, marine vessels, aircraft, mining vehicles, agricultural vehicles, or other off-highway vehicles. The vehicle systems described herein (rail vehicle systems or other vehicle systems that do not travel on rails or tracks) may be formed from a single vehicle or multiple vehicles. With respect to multi-vehicle systems, the vehicles may be mechanically coupled with each other (e.g., by couplers) or logically coupled but not mechanically coupled. For example, vehicles may be logically but not mechanically coupled when the separate vehicles communicate with each other to coordinate movements of the vehicles with each other so that the vehicles travel together (e.g., as a convoy).

In one example, a panel system is provided that may include a core body having opposite sides and switching devices mounted to at least one of the opposite sides of the core body, a housing in which the core body and the switching devices are disposed, gate drivers coupled to a first side of the housing and to the switching devices, and connectors coupled to one or more other sides of the housing and to the switching devices. The connectors may receive and conduct a voltage to collector terminals of the switching devices. The gate drivers may conduct a gate voltage to gate terminals of the switching devices. The switching devices may control conduction of the voltage out of the housing via the connectors as an alternating current.

The core body may include fluid ports configured to be coupled with a fluid circuit and internal conduits configured to direct flow of a cooling or heating fluid from the fluid circuit through the core body for thermal management of the switching devices. The fluid ports of the core body may extend through and protrude from the back side of the housing for connection with the fluid circuit. The housing may include guiding pins protruding from the back side of the housing for aligning the fluid ports of the core body with the fluid circuit. The connectors may include supply connectors on a second side of the one or more other sides of the housing and load connectors on a third side of the one or more other sides of the housing. The switching devices may be disposed in a side-by-side arrangement on each of the sides of the core body with a first switching device of the switching devices on each of the sides of the core body located closer to the second side of the housing than a second switching device of the switching devices on each of the sides of the core body. The second switching device on each of the sides of the core body may be located closer to the third side of the housing than the third switching device on each of the sides of the core body.

The housing may include one or more handles disposed on the first side of the housing with the gate drivers. The panel system optionally may include a top busbar coupled with the switching devices on a first side of the opposite sides of the core body and a bottom busbar coupled with the switching devices on a second side of the opposite sides of the core body, each of the top busbar and the bottom bus bar also connected with the connectors. One or both of the top busbar and the bottom busbar may include a multi-layer stack comprising outer dielectric protective layers, an internal dielectric layer, a first conductive layer between one of the outer dielectric protective layers and the internal dielectric layer, and a second conductive layer between another of the outer dielectric protective layers and the internal dielectric layer. The switching devices may be insulated gate bipolar transistors (IGBTs).

In another example, a method is provided that may include removing a top or a bottom busbar from a panel system having a core body with switching devices mounted to opposite sides of the core body, a housing in which the core body and the switching devices are disposed, gate drivers coupled to a first side of the housing, and connectors coupled to other sides of the housing and to the switching devices. The method also may include removing at least one of the switching devices from the core body, coupling a replacement switching device to the core body where the at least one of the switching devices was removed, and coupling the top or the bottom busbar to the panel system.

In another example, a kit is provided. The kit may be used in replacing at least one switching device coupled to a core body in a housing of a panel system also having gate drivers coupled to a first side of the housing and connectors coupled to other sides of the housing and to the switching devices. The kit may include a replacement switching device configured to be mounted to the core body.

In another example, another panel system may include a core body having opposite sides and switching devices mounted to at least one of the opposite sides of the core body. The core body may include internal conduits for flow of a fluid used to thermally manage the switching devices. The panel system may include a housing in which the core body and the switching devices are disposed, gate drivers coupled to a front side of the housing and to the switching devices, and supply connectors coupled to a first side of the housing and load connectors coupled to a second side of the housing with the front side disposed between the front side and the second side. The supply connectors may receive and conduct a voltage to collector terminals of the switching devices. The gate drivers may conduct a gate voltage to gate terminals of the switching devices. The switching devices may control conduction of the voltage out of the housing via the load connectors as an alternating current.

The core body may include fluid ports that can be coupled with a fluid circuit for receiving the fluid used to thermally manage the switching devices. The fluid ports of the core body may extend through and protrude from the back side of the housing for connection with the fluid circuit. The housing may include guiding pins protruding from the back side of the housing for aligning the fluid ports of the core body with the fluid circuit. The switching devices may be disposed in a side-by-side arrangement on each of the sides of the core body with a first switching device of the switching devices on each of the sides of the core body located closer to the second side of the housing than a second switching device of the switching devices on each of the sides of the core body. The second switching device on each of the sides of the core body may be located closer to the third side of the housing than the third switching device on each of the sides of the core body.

The housing may include one or more handles disposed on the front side of the housing with the gate drivers. The panel system also may include a top busbar coupled with the switching devices on a first side of the opposite sides of the core body and a bottom busbar coupled with the switching devices on a second side of the opposite sides of the core body. Each of the top bus bar and the bottom bus bar may be connected with the connectors. One or both of the top busbar and the bottom busbar may include a multi-layer stack comprising outer dielectric protective layers, an internal dielectric layer, a first conductive layer between one of the outer dielectric protective layers and the internal dielectric layer, and a second conductive layer between another of the outer dielectric protective layers and the internal dielectric layer.

Use of phrases such as "one or more of ... and," "one or more of ... or," "at least one of ... and," and "at least one of ... or" are meant to encompass including only a single one of the items used in connection with the phrase, at least one of each one of the items used in connection with the phrase, or multiple ones of any or each of the items used in connection with the phrase. For example, "one or more of A, B, and C," "one or more of A, B, or C," "at least one of A, B, and C," and "at least one of A, B, or C" each can mean (1) at least one A, (2) at least one B, (3) at least one C, (4) at least one A and at least one B, (5) at least one A, at least one B, and at least one C, (6) at least one B and at least one C, or (7) at least one A and at least one C.

As used herein, an element or step recited in the singular and preceded with the word "a" or "an" do not exclude the plural of said elements or operations, unless such exclusion is explicitly stated. Furthermore, references to "one embodiment" of the invention do not exclude the existence of additional embodiments that incorporate the recited features. Moreover, unless explicitly stated to the contrary, embodiments "comprising," "comprises," "including," "includes," "having," or "has" an element or a plurality of elements having a particular property may include additional such elements not having that property. In the appended claims, the terms "including" and "in which" are used as the plain-English equivalents of the respective terms "comprising" and "wherein." Moreover, in the following claims, the terms "first," "second," and "third," etc. are used merely as labels, and do not impose numerical requirements on their objects. Further, the limitations of the following claims are not written in means-plus-function format and are not intended to be interpreted based on 35 U.S.C. § 112(f), unless and until such claim limitations expressly use the phrase "means for" followed by a statement of function devoid of further structure.

The above description is illustrative, and not restrictive. For example, the above-described embodiments (and/or aspects thereof) may be used in combination with each other. In addition, many modifications may be made to adapt a particular situation or material to the teachings of the subject matter without departing from its scope. While the dimensions and types of materials described herein define the parameters of the subject matter, they are exemplary embodiments. The scope of the subject matter should, therefore, be determined with reference to the appended claims, along with the full scope of equivalents to which such claims are entitled.

This written description uses examples to disclose several embodiments of the subject matter, including the best mode, and to enable one of ordinary skill in the art to practice the embodiments of subject matter, including making and using any devices or systems and performing any incorporated methods. The patentable scope of the subject matter is defined by the claims, and may include other examples that occur to one of ordinary skill in the art. Such other examples are intended to be within the scope of the claims if they have structural elements that do not differ from the literal language of the claims, or if they include equivalent structural elements with insubstantial differences from the literal languages of the claims.

## Claims

1. A panel system (100) comprising:
a core body (230) having opposite sides (336, 338) and switching devices (234) mounted to at least one of the opposite sides (336, 338) of the core body (230);
a housing (102) in which the core body (230) and the switching devices (234) are disposed;
gate drivers (120, 122) coupled to a first side of the housing (102) and to the switching devices (234); and
connectors (114, 116, 118) coupled to one or more other sides of the housing (102) and to the switching devices (234), the connectors (116, 118) configured to receive and conduct a voltage to collector terminals (246) of the switching devices (234), the gate drivers (120, 122) configured to conduct a gate voltage to gate terminals (246) of the switching devices (234), and the switching devices (234) configured to control conduction of the voltage out of the housing (102) via the connectors (114, 116, 118) as an alternating current.

2. The panel system (100) of claim 1, wherein the core body (230) includes fluid ports (224) configured to be coupled with a fluid circuit and internal conduits configured to direct flow of a cooling or heating fluid from the fluid circuit through the core body (230) for thermal management of the switching devices (234).

3. The panel system (100) of claim 2, wherein the fluid ports (224) of the core body (230) extend through and protrude from a back side of the housing (102) for connection with the fluid circuit.

4. The panel system (100) of claim 3, wherein the housing (102) includes guiding pins (228) protruding from the back side of the housing (102) for aligning the fluid ports (224) of the core body (230) with the fluid circuit.

5. The panel system (100) of claim 1, wherein the connectors (114, 116, 118) include supply connectors (114) on a second side of the one or more other sides of the housing (102) and load connectors (118) on a third side of the one or more other sides (336, 338) of the housing (102).

6. The panel system (100) of claim 5, wherein the switching devices (234) are disposed in a side-by-side arrangement on each of the sides (336, 338) of the core body (230) with a first switching device (234) of the switching devices (234) on each of the sides (336, 338) of the core body (230) located closer to the second side of the housing (102) than a second switching device (234) of the switching devices (234) on each of the sides (336, 338) of the core body (230), and
the second switching device (234) on each of the sides (336, 338) of the core body (230) located closer to the third side of the housing (102) than the third switching device (234) on each of the sides (336, 338) of the core body (230).

7. The panel system (100) of claim 1, wherein the housing (102) includes one or more handles (104) disposed on the first side of the housing (102) with the gate drivers (120, 122).

8. The panel system (100) of claim 1, further comprising a top busbar (108) coupled with the switching devices (234) on a first side of the opposite sides (336, 338) of the core body (230) and a bottom busbar (108) coupled with the switching devices (234) on a second side of the opposite sides (336, 338) of the core body (230), each of the top busbar (108) and the bottom bus bar (108) also connected with the connectors (116, 118).

9. The panel system (100) of claim 8, wherein one or both of the top busbar (108) and the bottom busbar (108) includes a multi-layer stack comprising outer dielectric protective layers (548, 550), an internal dielectric layer (556), a first conductive layer (552) between one of the outer dielectric protective layers (548) and the internal dielectric layer (556), and a second conductive layer (554) between another of the outer dielectric protective layers (550) and the internal dielectric layer (556).

10. The panel system (100) of claim 1, wherein the switching devices (234) are insulated gate bipolar transistors (IGBTs).

11. A method comprising:
removing a top or a bottom busbar (108) from a panel system (100) having a core body (230) with switching devices (234) mounted to opposite sides (336, 338) of the core body (230), a housing (102) in which the core body (230) and the switching devices (234) are disposed, gate drivers (120, 122) coupled to a first side of the housing (102), and connectors (116, 118) coupled to other sides of the housing (102) and to the switching devices (234);
removing at least one of the switching devices (234) from the core body (230);
coupling a replacement switching device (234) to the core body (230) where the at least one of the switching devices (234) was removed; and
coupling the top or the bottom busbar (108) to the panel system (100).

12. A kit for use in replacing at least one switching device (234) coupled to a core body (230) in a housing (102) of a panel system (100) also having gate drivers (120, 122) coupled to a first side of the housing (102) and connectors (116, 118) coupled to other sides of the housing (102) and to the switching devices (234), the kit comprising a replacement switching device (234) configured to be mounted to the core body (230).

13. A panel system (100) comprising:
a core body (230) having opposite sides (336, 338) and switching devices (234) mounted to at least one of the opposite sides (336, 338) of the core body (230), the core body (230) including internal conduits for flow of a fluid used to thermally manage the switching devices (234);
a housing (102) in which the core body (230) and the switching devices (234) are disposed;
gate drivers (120, 122) coupled to a front side of the housing (102) and to the switching devices (234); and
supply connectors (116, 118) coupled to a first side of the housing (102) and load connectors (116, 118) coupled to a second side of the housing (102) with the first side disposed between the front side and the second side, the supply connectors (116, 118) configured to receive and conduct a voltage to collector terminals (246) of the switching devices (234), the gate drivers (120, 122) configured to conduct a gate voltage to gate terminals (246) of the switching devices (234), and the switching devices (234) configured to control conduction of the voltage out of the housing (102) via the load connectors (116, 118) as an alternating current.

14. The panel system (100) of claim 13, wherein the core body (230) includes fluid ports (224) configured to be coupled with a fluid circuit for receiving the fluid used to thermally manage the switching devices (234).

15. The panel system (100) of claim 14, wherein the fluid ports (224) of the core body (230) extend through and protrude from a back side of the housing (102) for connection with the fluid circuit.
